(19) Europäisches Patentamt

European Patent Office

Office européen des brevets

(11) **EP 1 650 325 A1**

(12) **EUROPEAN PATENT APPLICATION**
published in accordance with Art. 158(3) EPC

(43) Date of publication:
**26.04.2006 Bulletin 2006/17**

(51) Int Cl.:
*C23C 16/40* (1985.01)      *C23C 16/455* (2000.01)
*B01J 35/02* (1974.07)      *C01G 23/07* (1980.01)

(21) Application number: **04747371.5**

(22) Date of filing: **06.07.2004**

(86) International application number:
**PCT/JP2004/009903**

(87) International publication number:
**WO 2005/005686 (20.01.2005 Gazette 2005/03)**

(84) Designated Contracting States:
**AT BE BG CH CY CZ DE DK EE ES FI FR GB GR HU IE IT LI LU MC NL PL PT RO SE SI SK TR**

(30) Priority: **10.07.2003 JP 2003272936**

(71) Applicant: **Sumitomo Titanium Corporation
Amagasaki-shi,
Hyogo 660-8533 (JP)**

(72) Inventors:
• **SHIMOSAKI, Shinji,
SUMITOMO TITANIUM CORPORATION
Amagasaki-shi,
Hyogo 660-8533 (JP)**

• **OGASAWARA, Tadashi,
SUMITOMO TITANIUM CORPORATION
Amagasaki-shi,
Hyogo 660-8533 (JP)**

• **NAGAOKA, Sadanobu,
SUMITOMO TITANIUM CORPORATION
Amagasaki-shi,
Hyogo 660-8533 (JP)**

• **MASAKI, Yasuhiro,
SUMITOMO METAL INDUSTRIES, LTD.
Osaka-shi,
Osaka 541-0041 (JP)**

(74) Representative: **Schrimpf, Robert et al
Cabinet Regimbeau,
20, rue de Chazelles
75847 Paris Cedex 17 (FR)**

(54) **METHOD FOR FORMING METAL OXIDE COATING FILM AND VAPOR DEPOSITION APPARATUS**

(57)   A photocatalytic composite material having a photocatalytic titanium oxide film on the surface of a substrate is produced by a CVD method in which $TiCl_4$ vapor is reacted with water vapor. The $TiCl_4$ vapor and the water vapor are injected into a vapor deposition chamber (9) through nozzles (5) and (6), respectively, such that the resulting two injected vapor streams meet before reaching the substrate, thereby mixing the two vapors. Within 3 seconds after this mixing, the mixed vapors are brought into contact with a substrate (1) which is moving in one direction. Preferably the $TiCl_4$ vapor is injected in a reverse direction with respect to the direction of movement of the substrate through a multi-orifice nozzle (5), while the water vapor is injected through a slit nozzle (6) disposed at a smaller angle with respect to the substrate.

*Fig. 1*

## Description

Technical Field

This invention relates to a process for forming a metal oxide film such as a titanium oxide film having a photocatalytic activity on the surface of a substrate by the CVD (chemical vapor deposition) technique, and to a vapor deposition apparatus which is suitable for use in this film forming process.

Background Art

The photocatalytic activity exhibited by titanium oxide has attracted attention in that it is effective for various environmental depollution treatments including deodorization, prevention of microbial growth, and prevention of fouling. In order to allow the photocatalytic activity of titanium oxide to be exerted, photocatalytic titanium oxide composite materials have been developed in which a film of a photocatalytic titanium oxide is formed on the surface of a substrate selected from a wide variety of materials.

Practical methods for the formation of a titanium oxide film for use as a photocatalyst are roughly classified into an application method and a CVD method. The CVD method is capable of providing a substrate with a high photocatalytic activity by means of a thin film, thereby forming a photocatalytic functional product having a long service life.

In a typical CVD method for the formation of a titanium oxide film, a vapor of titanium tetrachloride ($TiCl_4$) is hydrolyzed by reaction with water vapor at the surface of a substrate to form a film of a titanium oxide precursor on the substrate. The substrate is then calcined to convert the titanium oxide precursor which forms the film into titanium oxide. The $TiCl_4$ used as a reactant may be replaced by another hydrolyzable titanium compound such as a titanium alkoxide, but from a commercial standpoint, the use of $TiCl_4$ is advantageous since it is less expensive and has a lower boiling point.

With respect to the formation of a photocatalytic titanium oxide film by the CVD technique using $TiCl_4$ as a reactant, JP-A 2000-262904 and JP-A 2000-266902 disclose a method in which calcination is performed by heating the substrate at a temperature in the range of 500 - 900 °C. $H_2O$ which is necessary for hydrolysis of $TiCl_4$ is supplied from the water vapor in air. Thus, $H_2O$ is provided from the surrounding atmosphere or by introducing humidified air into a vapor deposition chamber, if desired. A titanium oxide film formed by this method has a photocatalytic activity, but the activity itself is not very high. The film is also disadvantageous in that a smooth surface cannot be obtained due to a large crystallite size and in that the film has poor adhesion and tends to readily peel off.

In the above-described CVD method, since the reactivity between $TiCl_4$ vapor and water vapor (i.e., $TiCl_4$ and $H_2O$ in their gaseous phases) is very high, a hydrolysis reaction proceeds from the moment these two vapor reactants contact. Consequently, before $TiCl_4$ vapor reaches the target substrate on which vapor deposition is to occur, a reaction occurs in the gas phase (i.e., in the gas space within a vapor deposition chamber) to form a powder reaction product, leading to a wasteful consumption of $TiCl_4$ vapor. As a result, this method has another problem that the rate of film formation on a substrate and the utilization factor (percentage) of $TiCl_4$ for film formation are both low.

For commercial production of a photocatalytic titanium oxide composite material by the CVD technique, there is a need for a vapor deposition method which is free from the above-described problems and which is capable of continuously and stably forming a titanium oxide film with a uniform thickness on the surface of a substrate having a large area.

However, in a conventional vapor deposition method, since a reaction between $TiCl_4$ vapor and water vapor in the gas phase cannot be prevented effectively, it is not possible to attain satisfactory productivity and a satisfactory utilization factor of $TiCl_4$, and the resulting $TiCl_4$ film has a film thickness which is not uniform. In addition, the powder product that was formed by a reaction in the gas phase deposits on the surface of the substrate while the substrate is subjected to vapor deposition so that the product thus produced (a photocatalytic titanium oxide composite material) has a deteriorated appearance, which is another problem.

Accordingly, it is still desired in the commercial production of a photocatalytic titanium oxide composite material by the CVD technique to provide a film forming process capable of forming a film of uniform thickness with high productivity and a high utilization factor of $TiCl_4$ and a vapor deposition apparatus for use in that process.

Disclosure of the Invention

In the formation of a titanium oxide film by the CVD technique using hydrolysis of $TiCl_4$, a very high reactivity between $TiCl_4$ vapor and water vapor allows the $TiCl_4$ vapor to prematurely react with the water vapor in the gas phase (namely, in the gas space within a vapor deposition chamber) before it reaches a substrate, which causes the above-described various problems. In order to prevent the premature reaction, it becomes necessary to control contact between the $TiCl_4$ vapor and water vapor such that the undesirable hydrolysis in the gas phase is prevented as much as possible.

However, a conventional method utilized water vapor contained in air, and water vapor was usually supplied from the surrounding atmosphere or air. Therefore, the concentration of water vapor in a vapor deposition chamber had a uniform or slightly varying distribution. As a result, $TiCl_4$ vapor fed into the vapor deposition chamber immediately reacted with water vapor which existed in its surroundings, and a hydrolysis reaction in the gas phase could not be controlled. Namely, in the prior art, it was not considered to control contact between $TiCl_4$ vapor and water vapor in the gas phase.

The present inventors investigated the above-described CVD film formation method from the new point of view that the progress of a reaction of $TiCl_4$ and $H_2O$ in the gas phase is suppressed by controlling contact of $TiCl_4$ vapor supplied as a reactant with water vapor. As a result, it was found that injection of jetted streams of both the $TiCl_4$ vapor and the water vapor through respective nozzles makes it possible to control the time at which these two vapors are allowed to contact and mix, which in turn makes it possible to control within a proper range the time elapsed from mixing of the two vapors until the mixed vapors contact a substrate, thereby significantly preventing a reaction between $TiCl_4$ and $H_2O$ from proceeding in the gas phase and leading to elimination of the above-described problems.

Specifically, by bringing $TiCl_4$ vapor into contact with a substrate within 3 seconds and preferably within one second from its mixing with water vapor, the occurrence of a hydrolysis reaction of $TiCl_4$ in locations other than at the surface of the substrate can be suppressed. Thus, a significant improvement in the rate of film formation and in the utilization factor of $TiCl_4$ for film formation is achieved, and it is made possible to form a titanium oxide film having a uniform thickness and good appearance.

Although the reason for this has not been elucidated completely, it is thought that due to limitation of the time from contact and mixing of the two vapors by collision before they reach the substrate as described above, the two vapors may arrive at the surface of the substrate while they are mixed only on a macroscopic scale but not completely mixed on a microscopic scale (hence, such that a reaction between $TiCl_4$ and $H_2O$ is suppressed). It is also conceivable that the possibility of $TiCl_4$ vapor contacting the substrate is increased, which contributes to an improved rate of film formation.

The type of vapor deposition in which the above-described effects can be attained is not restricted to the cases in which $TiCl_4$ is reacted with $H_2O$. When a chloride of another metal or a non-chloride type of a hydrolyzable metal compound such as an alkoxide is used in place of $TiCl_4$, improvements in the utilization factor of the vapor deposition reactant (metal compound) and the uniformity and appearance of the resulting film can also be obtained, although the degree of improvement may vary.

According to a first aspect, the present invention is a process for forming a metal oxide film comprising a vapor deposition step in which a vapor of a hydrolyzable metal compound and water vapor are brought into contact with a substrate to form a film of a metal oxide precursor on the surface of the substrate and a calcination step in which the substrate is then heated in an oxidizing atmosphere to convert the precursor into a metal oxide, characterized in that in the vapor deposition step, the hydrolyzable metal compound vapor and the water vapor are previously mixed and the mixed vapors are brought into contact with the substrate within 3 seconds after mixing. The present invention directed to this process may hereinafter be referred to as a first invention.

When the above-described film forming process is conducted on an industrial scale, it is advantageous from the standpoint of productivity to employ a continuous operation in which the substrate is sequentially subjected to the vapor deposition step and the calcination step while it is continuously moved forward. In the process according to the present invention, the vapor deposition step is preferably carried out by injection of jetted streams of a vapor of a hydrolyzable metal compound and water vapor toward the substrate which is continuously moving or traveling. In this case, mixing of the vapors can be performed by allowing the jetted streams of the hydrolyzable metal compound vapor and water vapor to meet each other before they reach the substrate. Preferably, the hydrolyzable metal compound vapor is injected in a reverse (backward) direction with respect to the direction of movement of the substrate through a multi-orifice nozzle and the water vapor is injected through a slit nozzle.

In the first invention, the hydrolyzable metal compound used as a vapor deposition reactant is preferably a metal chloride (e.g., $TiCl_4$), but a metal alkoxide (e.g., a tetralkoxy-titanium) may also be used. The metal species is not limited to Ti, and the first invention can also be applied to the formation of an oxide film of a metal selected from various other metals such as Si, Sn, Zr, Zn, Sb, In, W, and Ta. The oxide film may contain two or more metals.

Examples of metal oxides having a photocatalytic activity to which the first invention can be applied for film formation include titanium oxide, tin oxide, zinc oxide, zirconium oxide, tungsten oxide, and the like. As is well known, a slight amount of a doping element may be added in order to increase or modify the photocatalytic activity. Examples of metal oxides other than photocatalysts include but are not limited to ITO (indium-tin oxide or tin-containing indium oxide) and antimony-containing tin oxide which are useful as a transparent conducting film, silicon oxide which serves as an insulating film, and the like. Some metal oxides having a photocatalytic activity are also useful for other purposes. For example, zinc oxide can be used as a UV absorber and a conducting film.

For the formation of an oxide film containing two or more metals such as an ITO film, the hydrolyzable metal compound vapor contains two or more hydrolyzable metal compounds. This is also the case when a doping element is incorporated into the metal oxide film.

From another aspect, the present invention is a vapor deposition apparatus for forming a film on the surface of a continuously moving substrate by a reaction between two vapors, characterized in that the apparatus comprises a multi-orifice nozzle and a slit nozzle disposed in such directions that the these nozzles inject vapor streams which meet each other. The present invention directed to this vapor deposition apparatus may hereinafter be referred to as a second invention.

The vapor deposition apparatus according to the second invention can not only be used for the formation of a metal oxide film according to the first invention but can also be widely used for film formation by the CVD technique of various other materials formed by a reaction between two vapors. This apparatus is particularly useful when the problem exists of a high reactivity between the two vapor reactants. Examples of film materials other than metal oxides described above with respect to the first invention include gallium nitride (a blue light emitting diode) formed by a reaction between gallium chloride or trimethylgallium and ammonia, gallium arsenide (a compound semiconductor) formed by a reaction between arsine and trimethylgallium, silicon carbide (a compound semiconductor or the like) formed by a reaction between a monosilane and propane, and the like.

Brief Description of the Drawing

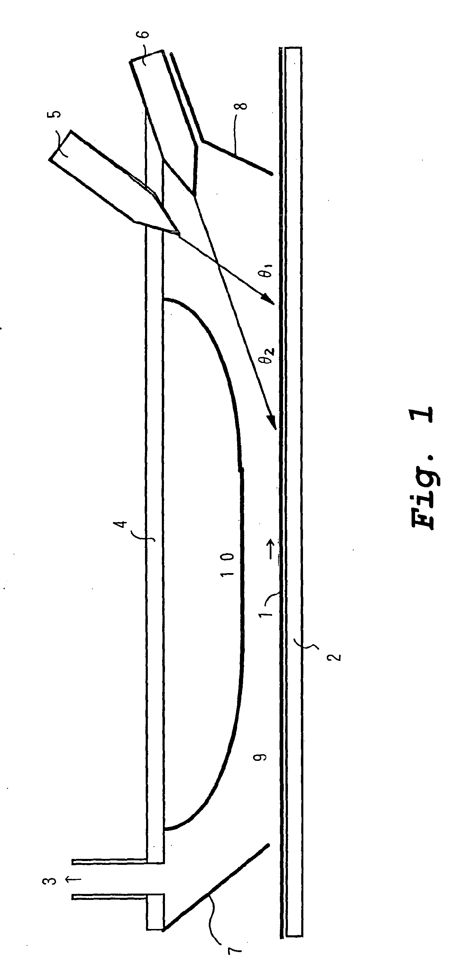

Figure 1 is a schematic diagram showing an example of a vapor deposition apparatus according to the second invention.

Best Mode for Carrying Out the Invention

Below, the first and second inventions are described more fully with respect to the formation of a titanium oxide film by a reaction of $TiCl_4$ vapor and water vapor, namely, or an embodiment of the first invention in which the hydrolyzable metal compound is $TiCl_4$, taken as an example. However, as described above, other hydrolyzable metal compounds may be used for the first invention, and in the second invention, the two vapors are not restricted as long as they can react to form a film.

The first invention relates to a process for producing a titanium oxide composite material comprising a vapor deposition step in which $TiCl_4$ vapor and water vapor (or $TiCl_4$ and $H_2O$ in gaseous phases) are brought into contact with a substrate to form a film of a titanium oxide precursor on the surface of the substrate and a calcination step in which the substrate is then heated in an oxidizing atmosphere to form a film of a titanium oxide photocatalyst on the surface of the substrate. According to the first invention, the $TiCl_4$ vapor and the water vapor used in the vapor deposition step are previously mixed, and the mixed vapors are brought into contact with the substrate within 3 seconds and preferably within 1 second after mixing.

A means for performing the previous mixing of the vapors is not restricted to any particular type, but in view of the time interval of at most 3 seconds between this mixing and subsequent contact of the mixed vapors with the substrate, it is actually practical to mix the two vapors in a vapor deposition chamber. In order to allow the resulting mixed vapors to contact the substrate within 3 seconds after mixing, mixing may be performed by injection of jetted streams of the $TiCl_4$ vapor and water vapor through respective nozzles toward the substrate such that the two injected vapor streams meet each other before they reach the substrate.

The substrate may be continuously subjected to vapor deposition by continuously moving it in one direction to pass through the vapor deposition chamber. Thus, film formation in continuous operation in which the condition defined by the first invention that the mixed vapors are brought into contact with the substrate within 3 seconds and preferably within 1 second after mixing is satisfied can be performed by injecting the $TiCl_4$ vapor and water vapor toward the substrate so as to form two jetted streams of vapor which meet each other while the substrate is being continuously moved. This procedure has good operational efficiency and is suitable for commercial production of a photocatalytic titanium oxide composite material.

The time interval which elapses between mixing of the two vapors and subsequent contact of the mixed vapors with the substrate can be measured by the following method, for example. First, a video camera is set inside a vapor deposition chamber (or it may be set on the outside of a vapor deposition chamber if the chamber has an appropriate viewing window) so that the jetted streams of the vapors can be observed. A jetted stream of water vapor is initially formed in the chamber. Injection of a jetted stream of $TiCl_4$ vapor is then started in such a direction that it meets the jetted stream of water vapor. The interval from the time at which it reaches the meeting point (mixing point) to the time at which it then reaches the substrate can be determined from the video image recorded immediately after the start of injection of a jetted stream of $TiCl_4$ vapor. The time required for the $TiCl_4$ vapor stream to reach the meeting point or the substrate can be accurately measured with a video camera capable of high speed photography. If it is difficult to perform such measurement at the time of starting the injection of $TiCl_4$ vapor, the measurement may be performed at the time of terminating the injection thereof. The above-mentioned measurement of the time can also be performed by transiently varying the injection pressure of the jetted stream of $TiCl_4$ vapor (by applying a noise to the injection pressure) while the vapor is being injected.

If the time interval elapsed after mixing of the $TiCl_4$ vapor and water vapor and before the mixed vapors contact the substrate exceeds 3 seconds, a reaction in a gas phase occurs significantly before the mixed vapors reach the substrate, thereby resulting in the formation of a significantly increased amount of a powder reaction product. The powder is mostly discharged from the vapor deposition chamber by being entrained by the flows of the injected vapors, but part of the powder remains on the substrate. Thus, a large proportion of the injected $TiCl_4$ vapor runs to waste, and therefore the rate of film formation is decreased and the utilization factor of $TiCl_4$ is significantly decreased. Part of the powder adheres to the surface of the substrate, but it tends to be easily removed therefrom since it does not form a film. Whether the powder is removed from the substrate or remains adhering thereto, it worsens the appearance and particularly the smoothness of the film.

Figure 1 shows a schematic diagram of an embodiment of a vapor deposition apparatus which can be used in the above-described vapor deposition step according to the present invention. The vapor deposition apparatus shown in Figure 1 comprises a carrying member 2 such as a conveyer which is capable of allowing a substrate 1 placed thereon to continuously travel in one direction and an upper wall member 4 having a vapor exhaust port (outlet) 3. Two nozzles 5, 6 for injection of jetted streams of vapors extend through the upper wall member 4 in such directions that these nozzles form jetted streams of vapors which meet each other. In the illustrated embodiment, the apparatus has an upper nozzle 5 directed at an angle closer to the vertical and a lower nozzle 6 directed at an angle closer to the horizontal. Preferably, each of these nozzles is one which is capable of injecting a vapor relatively uniformly over the entire width of the substrate, such as a slit nozzle or a multi-orifice nozzle.

Baffles 7, 8 are attached to the opposite ends of the upper wall member 4 so as to leave a gap from the underlying carrying member 2 for allowing the substrate 1 to pass through the gap. A vapor deposition chamber 9 is constituted by the space enclosed by the carrying member 2, the upper wall member 4, and the baffles 7, 8 on both sides. In the illustrated embodiment, a guide 10 is attached to the upper wall member 4 in order to reduce the volume of the vapor deposition chamber 9. As a result, the vapor streams injected through nozzles 5, 6 can be brought into contact with the substrate more efficiently and directed to the vapor exhaust port 3 more smoothly.

Although not illustrated, an oven for calcination is located ahead of the vapor deposition apparatus with respect to the direction of movement of the substrate (namely downstream of the apparatus) so that the substrate which has been subjected to vapor deposition in the vapor deposition chamber is then passed through the oven in which it is calcined. In this manner, a photocatalytic titanium oxide composite material can be produced continuously.

In a vapor deposition method such as a CVD method, unless vapor reactants contact a substrate uniformly, the thickness of a vapor deposited film formed on the substrate becomes non-uniform. Particularly when a vapor deposition step is carried out while the substrate is being advanced continuously, the processing from mixing of $TiCl_4$ vapor and water vapor used as reactants until contact of the mixed vapors with a substrate needs to proceed uniformly in a direction perpendicular to the direction of movement of the substrate (i.e., in a widthwise or transverse direction of the substrate, which may hereinafter be referred to simply as a transverse direction).

In order to cope with this problem, the present inventors investigated various nozzles and combinations thereof with the aim of injecting the vapor reactants uniformly in a transverse direction of the substrate. As a result, it was found that the most uniform film formation in a transverse direction of the substrate can be achieved by injecting $TiCl_4$ vapor through a multi-orifice nozzle in a reverse (backward) direction with respect to the direction of movement of the substrate and injecting water vapor through a slit nozzle in such a direction that the resulting jetted stream of water vapor meets the jetted stream of $TiCl_4$ vapor before the two vapor streams reach the substrate.

Thus, a vapor deposition apparatus comprising a multi-orifice nozzle and a slit nozzle disposed such that the two jetted vapor streams injected therethrough meet each other is the second invention. The vapor deposition apparatus can be used for film formation by a CVD method with a wide variety of reactants.

Considering the case where only one injection nozzle is provided, a slit nozzle disposed so as to extend in the widthwise direction of the substrate can achieve a state of injection which is uniform in a transverse direction. However, when two nozzles are disposed such that the two jetted vapor streams injected from these nozzles meet each other, with a combination in which both the injection nozzles are slit nozzles, it is difficult to mix the two vapors uniformly in a transverse direction. Namely, the state of film formation may become non-uniform and unstable due to factors such as a slight deviation in the geometric arrangement of a nozzle or the width of the slit gate thereof, or a variation in the flow rate of vapor injection.

In contrast, with a combination of a slit nozzle and a multi-orifice nozzle, it was found that mixing of the two vapors occurs such that the jetted vapor stream injected through each of the orifices of the multi-orifice nozzle which are arranged lengthwise in the nozzle breaks through the curtain-like jetted vapor stream injected through the slit nozzle, thereby improving the uniformity of film formation in a transverse direction.

Although there are many possibilities with respect to the arrangement of the two nozzles, they are disposed such that the two jetted vapor streams injected through the two nozzles meet and strike against each other to mix before they reach a substrate and the mixed vapors reach the substrate within 3 seconds after mixing of the vapors has occurred.

Either the slit nozzle or the multi-orifice nozzle may be disposed in a higher position. However, a more uniform film formation can be achieved when the multi-orifice nozzle is disposed as an upper nozzle.

The upper multi-orifice nozzle is preferably disposed in a tilted position such that it injects a jetted vapor stream in a reverse (backward) direction with respect to the direction of movement of the substrate, since this position minimizes the amount of the vapor which diffuses as the substrate moves. It is also preferable that $TiCl_4$ vapor be injected through the upper multi-orifice nozzle with water vapor being injected through the lower slit nozzle. Thus, since the tilt angle of the upper nozzle through which $TiCl_4$ vapor is injected is closer to the vertical (than that of the other nozzle), the angles of the center lines of the streams of $TiCl_4$ vapor and water vapor with respect to the surface of the substrate (these angles being expressed as θM and $θH_2O$, respectively) have the relationship $θM > θH_2O$. The angles of the center lines of these vapor streams are equal to the tilt angles of the axes of the corresponding nozzles with respect to the surface of the substrate.

The tilt angle of the upper multi-orifice nozzle through which $TiCl_4$ vapor is injected with respect to the substrate surface (depicted as $θ_1$ in Figure 1, that is, the angle of the center line of the injected $TiCl_4$ vapor stream, θM) is preferably $30° \leq θM \leq 80°$. The reason why 8M is made at least 30° (30 degrees) is that as the angle of the $TiCl_4$ vapor which is injected toward the surface of the substrate increases, the length of the path of the vapor stream until it contacts the substrate decreases, so vapor diffusion is decreased and an increased rate of film formation is obtained. The reason why θM is at most 80° is that if this injection angle is close to 90°, the proportion of the powder formed in the gas phase which deposits on the substrate significantly increases. The value of θM is preferably between 45° and 75°. The value of $θH_2O$ (depicted as $θ_2$ in Figure 1) should be smaller than that of θM, and preferably it is between 10° and 40°.

With respect to the flow rates of the jetted vapor streams injected through these nozzles, it is desirable to set the flow rates so as to satisfy the following relationship:

(flow rate of vapor stream through upper nozzle) > (flow rate of vapor stream through lower nozzle), or in the above-described embodiment,

(flow rate of $TiCl_4$ vapor stream) > (flow rate of water vapor stream). If (flow rate of vapor stream through upper nozzle) < (flow rate of vapor stream through lower nozzle), the vapor stream injected through the upper nozzle is overcome by the vapor stream injected through the lower nozzle, so the proportion of the vapor injected through the upper nozzle which contacts the substrate decreases, resulting in a decreased rate of film formation on the substrate.

When $TiCl_4$ vapor is injected through a multi-orifice nozzle, the pitch of the orifices of the nozzle is preferably from 3 mm to 10 mm. If the pitch of the orifices of the multi-orifice nozzle is too large, there may be portions in which a transversely uniform jetted stream of water vapor injected through a slit nozzle does not mix the jetted stream of $TiCl_4$ vapor injected through the multi-orifice nozzle. If the pitch of the orifices of the multi-orifice nozzle is too small, the $TiCl_4$ vapor stream coming from a higher position is nearly uniform transversely (in other words, it is close to a state of vapor stream injected through a slit nozzle), so it is difficult to obtain the desired proper mixing attributable to "a combination of a slit nozzle and a multi-orifice nozzle".

In the vapor deposition of a titanium oxide film using $TiCl_4$ vapor and water vapor, it is difficult to reduce the formation of a powder reaction product to zero due to the formation of nuclei in the gas phase. However, in order to prevent the powder product formed in the gas phase from depositing on the substrate, as shown in Figure 1, the apparatus may be provided with a mechanism for forcedly exhausting the reactant vapors, such as a vapor exhaust port 3 near the front (distal) end of the vapor deposition chamber 9 when viewed in the vapor injecting direction, and with baffles 7, 8 disposed on the outside of the vapor-injecting nozzles and of the vapor exhaust port for preventing the reactant vapors from diffusing, thereby making it possible to significantly decrease the deposition of a powder product on the substrate.

Furthermore, in order to increase the efficiency of utilization of the reactant vapors, a guide 10 which serves to decrease the vertical cross section of the vapor deposition chamber 9 through which the vapors pass may be placed to improve the efficiency of contact of the reactant vapors with the substrate, thereby making it possible to carry out the vapor deposition with an increased efficiency.

Two or more sets each comprising the two nozzles for vapor injection and the vapor exhaust port as depicted may be arranged in series along the direction of movement of the substrate, thereby making it possible to increase the moving (traveling) speed of the substrate and improve the rate of production. In this case, the baffles may be provided either only on opposite ends of the row of all the sets or on opposite ends of each set.

From the standpoints of the rate of film formation and the utilization factor of $TiCl_4$, both the $TiCl_4$ vapor and the water vapor as reactants are preferably fed for vapor deposition in the form of a diluted vapor in which the vapor is diluted with an appropriate gas. If the concentration of the reactant vapor in the diluted vapor is too high, the proportion of reactions occurring in the gas phase increases, and the utilization factor of the $TiCl_4$ reactant and the rate of film formation on the substrate both decrease. Preferably, the concentrations of $TiCl_4$ and $H_2O$ in their respective diluted vapors to be fed for vapor deposition are each in the range of from 0.1 % to 10%. A gas which can be used for dilution may be dry air or an inert gas (e.g., nitrogen or argon).

The ratio of TiCl$_4$ vapor to water vapor which are fed is preferably such that the H$_2$O/TiCl$_4$ molar ratio is in the range of from 0.05 to 4. If this molar ratio is less than 0.05, the proportion of TiCl$_4$ is so small that the rate of film formation is decreased. If this molar ratio is greater than 4, the proportion of TiCl$_4$ which is consumed for the formation of a powder product in the gas phase is increased, so the utilization factor of TiCl$_4$ is decreased and the amount of a powder product deposited on the substrate is increased, resulting in worsening the appearance of the film product. The above-described molar ratio is preferably in the range of from 0.1 to 3 in order to make it possible to carry out film formation more efficiently.

In the case of using TiCl$_4$ as a reactant for vapor deposition, the temperature of the substrate in the vapor deposition step is preferably in the range of from 150 to 250 °C. If the substrate temperature is lower than 150 °C, a uniform film cannot be formed, and the vapor deposited film instead has a powdery appearance with a decreased adhesion of the film to the substrate. On the other hand, if the substrate temperature is higher than 250 °C, the crystal grains constituting the vapor deposited titanium oxide film become significantly coarse, thereby adversely affecting the photocatalytic activity of the film and its adhesion to the substrate. The substrate temperature is the temperature at which the mixed TiCl$_4$ vapor and water vapor contact the substrate, and it is not necessary to maintain the substrate temperature throughout the inside of the vapor deposition chamber, particularly on the upstream side of the chamber. The substrate temperature may be adjusted by one or more suitable means. For example, the substrate may be preheated by a suitable heating means prior to the vapor deposition step, the carrying member used for conveying the substrate may be provided with a heating means, and/or the substrate may be heated by the heat of the vapor deposition chamber which is heated. The temperature in the vapor deposition chamber is set such that the TiCl$_4$ vapor and water vapor do not condense at that temperature.

When it is desired to form a composite film of titanium oxide with SiO$_2$, SnO$_2$, and/or ZrO$_2$, TiCl$_4$ vapor or its diluted vapor which is being fed may incorporate a vapor of a halide of Si, Sn, and/or Zr, before it is mixed with water vapor. Thus, a composite titanium oxide film in which mixing occurs more uniformly can be obtained. Similarly, in the case of doping with a different transition metal, TiCl$_4$ vapor or its diluted vapor which is being fed may incorporate a halide or an oxyhalide of the transition metal, thereby making it possible to obtain a titanium oxide film which is doped uniformly at the atomic level.

After the vapor deposition step, the substrate on which a film of a titanium oxide precursor is formed by vapor deposition is heated in the subsequent calcination step to convert the titanium oxide precursor into titanium oxide which is at least partially crystalline, thereby producing a photocatalytic titanium oxide composite material having a titanium oxide film on its surface. The heating temperature in the calcination step is preferably from 300 - 600 °C and more preferably from 400 - 500 °C so as to form titanium oxide crystals of the anatase form which has a high photocatalytic activity. If calcination is performed at a temperature higher than 600 °C, the crystal forms of the resulting titanium oxide may include a rutile phase, thereby causing the catalytic activity to decrease. Calcination at a temperature lower than 300 °C makes crystallization insufficient to attain a high catalytic activity. The calcination atmosphere is not critical, and atmospheric air is adequate.

When using a reactant for vapor deposition other than TiCl$_4$, the vapor deposition conditions may be varied appropriately. In addition, when the film product is other than titanium oxide, the calcination conditions may also be varied appropriately so as to form an oxide film having optimal properties.

The material which is used as a substrate is not restricted as long as it can withstand the calcination. Since the present invention uses a vapor phase deposition technique, it is possible to use substrates having a wide variety of shapes on which uniform vapor deposition is performed. Uniform vapor deposition can be achieved, for example, on substrates in sheet form such as glass, ceramics, and metals, on fibrous substrates such as glass cloth and glass filters, and substrates with an irregular shape such as porous ceramics, spheres, pebbles, and fragmented pieces. The thickness of the titanium oxide film is not restricted, but it is preferably at least 30 nm so as to exhibit a sufficiently high photocatalytic activity. Usually, the film thickness is in the range of 300 - 1000 nm. When the intended use of the film is other than a photocatalyst, the thickness of the metal oxide film may be selected appropriately depending on the use.

Examples

(Example 1)

A quartz plate used as a substrate was placed at an angle of 20° with respect to the horizontal in a quartz tube which was disposed horizontally. At one end of the quartz tube, TiCl$_4$ vapor and water vapor used as reactants for vapor deposition were injected through respective single-orifice nozzles to form jetted streams of vapor and were discharged from the other end of the tube to perform a vapor deposition test.

The TiCl$_4$ vapor and the water vapor were diluted with argon and dry air, respectively, to form each into a diluted vapor having a concentration of 3%, which was used for injection. The atmosphere in the tube before injection of the vapors was an argon atmosphere. The temperature of the substrate was made 180 °C by heating the tube at 180 °C with an external heater. In order to prevent condensation of the $TiCl_4$ vapor and the water vapor, each diluted vapor was heated by heating its feed pipe to the inlet of the quartz tube at 60 °C. The two nozzles were tilted at such angles that the vapor streams injected therethrough met each other in the quartz tube, and the flow rates of these vapors injected through the respective nozzles were adjusted to give a $H_2O/TiCl_4$ molar ratio of 0.5.

In this example, the position of the substrate.in the quartz tube was varied to vary the length of time which elapsed from mixing of the $TiCl_4$ vapor and water vapor until contact of the mixed vapors with the substrate. This time was measured using a video image of the quartz tube taken from the outside at the start of vapor injection using a video camera capable of high-speed photography. The vapor deposition was continued for 3 minutes from the start of vapor injection.

Subsequently, the quartz plate substrate was withdrawn from the quartz tube and calcined by heating it for 60 minutes at 500 °C in an air oven to form a crystalline titanium oxide film of the anatase form on the surface of the substrate.

The thickness of the titanium oxide film was determined by mechanically removing the film in a limited area until the substrate appeared and measuring the resulting difference in level between the substrate and the film with a surface profilometer. The film thickness determined in this manner was divided by duration in time of vapor deposition to calculate the rate of film formation. In addition, the molar amount of Ti atoms present in the titanium oxide film was calculated from the film thickness, and the utilization factor of $TiCl_4$ was calculated as the ratio of the molar amount of Ti atoms in the film to the molar amount of $TiCl_4$ vapor supplied for vapor deposition. These results are shown in Table 1.

**Table 1**

| Time between mixing and contact with substrate [sec] | Rate of film formation [nm/min] | Utilization factor of $TiCl_4$ [%] |
|---|---|---|
| 0.5 | 200 | 12 |
| 0.8 | 125 | 8 |
| 1 | 100 | 6 |
| 2 | 50 | 3 |
| 3 | 30 | 2 |
| 5 | 10 | 0.6 |
| 10 | 7 | 0.4 |

It can be seen from the results in Table 1 that if the time elapsed from mixing of the $TiCl_4$ vapor and water vapor until contact of the mixed vapors with the substrate exceeds 3 seconds, both the rate of film formation and the utilization factor of $TiCl_4$ decrease significantly. When this time is 1 second or shorter, the rate of film formation and the utilization factor of $TiCl_4$ greatly increase.

(Example 2)

Vapor deposition and calcination were carried out in accordance with the procedure in Example 1 except for the following points. In this example, the position of the substrate in the quartz tube was fixed such that the time elapsed from mixing of the $TiCl_4$ vapor and water vapor until contact of the mixed vapors with the substrate was 2 seconds, while the temperature of the substrate was varied in the range of from 100 - 500 °C. The temperature of the substrate was controlled at a predetermined temperature by heating the quartz tube from the outside in an electric oven. For the same purpose as described in Example 1, the feed pipe of each diluted vapor to the inlet of the quartz tube was heated at 60 °C or higher.

The photocatalytic activity of each titanium oxide film formed on the substrate was evaluated by the aldehyde decomposition test described below. In addition, the adhesion of the titanium oxide film was tested by a tape peel test and evaluated as follows: mark "O" indicates no peeling and mark "X" indicates the occurrence of peeling of the film. The results of these tests are shown in Table 2 along with the temperature of the substrate.

Aldehyde Decomposition Test (Measurement of Photocatalytic Activity)

A test piece of the coated substrate measuring 40 mm square was put into a quartz reaction cell, and the cell was connected to a closed circulating line system (having a total internal volume of about 3.0 liter). A gas prepared by diluting acetaldehyde with a nitrogen gas containing 20 vol% of oxygen (to an acetaldehyde concentration of 250 ppm) was fed into the system. While the gas was circulated in the system, the reaction cell was irradiated with UV light from a mercury-vapor lamp. The irradiation dose of the UV light was 4 mW/cm². The reaction was monitored by periodically measuring the concentration of carbon dioxide, which was formed by decomposition of acetaldehyde, by an automated gas chromatograph connected to the circulating line. The photocatalytic activity was evaluated in terms of the rate of carbon dioxide formation.

Table 2

| Heating temperature of substrate [°C] | Rate of aldehyde decomposition [ppm/min] | Adhesion |
|---|---|---|
| 100 | 1.75 | X |
| 150 | 1.80 | O |
| 200 | 1.95 | O |
| 250 | 1.10 | O |
| 300 | 0.25 | O |
| 350 | 0.23 | X |
| 400 | 0.21 | X |
| 500 | 0.18 | X |

As shown by the results of Table 2, at a temperature of the substrate in the range of from 150 - 250 °C, the titanium oxide film had a high rate of aldehyde decomposition (photocatalytic activity) and good adhesion. At a lower temperature of the substrate, the adhesion decreased. Good adhesion was attained up to a substrate temperature of about 350 °C, but at a substrate temperature exceeding 250 °C, the photocatalytic activity decreased.

(Example 3)

Vapor deposition and calcination were carried out in the same manner as in Example 2 except for the following points. In this example, the temperature of the substrate was 180 °C, which was the same as in Example 1, but the ratio of $TiCl_4$ vapor to water vapor injected into the quartz tube ($H_2O/TiCl_4$ molar ratio) was varied.
The rate of film formation and the photocatalytic activity of each titanium oxide film formed on the substrate were evaluated as described in Examples 1 and 2, respectively, and the results are shown in Table 3.

Table 3

| $H_2O/TiCl_4$ molar ratio | Rate of aldehyde decomposition [ppm/min] | Rate of film formation [nm/min] |
|---|---|---|
| 0.1 | 0.79 | 50 |
| 0.5 | 1.95 | 200 |
| 1 | 1.56 | 150 |
| 2 | 1 | 130 |
| 3 | 0.85 | 110 |
| 5 | 0.79 | 75 |
| 10 | 0.83 | 50 |

As can be seen from Table 3, at a $H_2O/TiCl_4$ molar ratio of 5 or greater, the rate of film formation decreased. In view of the rate of film formation and the photocatalytic activity, the molar ratio is preferably 3 or lower, and in particular, at a molar ratio of about 0.5, both the rate of film formation and the photocatalytic activity were highest.

(Example 4)

Vapor deposition and calcination were carried out in the same manner as in Example 2 except for the following points. In this example, the temperature of the substrate was 180 °C, which was the same as in Example 1, but the concentration of $TiCl_4$ in the diluted $TiCl_4$ vapor injected into the quartz tube was varied in the range of from 0.05% to 20%. The $H_2O$ concentration in the diluted water vapor was also adjusted such that the $H_2O/TiCl_4$ molar ratio was 0.5.

The rate of film formation and the utilization factor of TiCl$_4$ were evaluated as described in Example 1, and the results are shown in Table 4.

Table 4

| Concentration of TiCl$_4$ [%] | Rate of film formation [nm/min] | Utilization factor of TiCl$_4$ [%] |
|---|---|---|
| 0.05 | 40 | 6 |
| 0.1 | 100 | 7 |
| 1 | 140 | 8 |
| 2 | 220 | 12 |
| 5 | 120 | 7 |
| 10 | 140 | 4 |
| 20 | 130 | 2 |

As shown in Table 4, when the concentration of TiCl$_4$ was in the range of from 0.1 to 10%, the rate of film formation and the utilization factor of TiCl$_4$ were good. With a TiCl$_4$ concentration which was too low, the rate of film formation decreased, while with a TiCl$_4$ concentration which was too high, the utilization factor of TiCl$_4$ decreased.

(Example 5)

Continuous vapor deposition was carried out on a substrate in the form of a strip having a width of 210 millimeters and a length of 300 meters using a vapor deposition apparatus as shown in Figure 1 which had two nozzles, an upper nozzle 5 and a lower nozzle 6, for injection of jetted streams of vapor while a substrate 1 was continuously moved in one direction. The substrate which was used was a glass cloth, and the speed of movement (traveling speed) of the substrate was 15 cm/min. The substrate was preheated such that the temperature of the substrate became 180 °C at the time of contact with the vapors injected through the nozzles.

TiCl$_4$ vapor was injected through the upper nozzle 5, and water vapor was injected through the lower nozzle 6. Both vapors were diluted vapors having a 2% concentration of TiCl$_4$ or H$_2$O diluted with argon for the TiCl$_4$ vapor and dry air for the water vapor. The amounts of the vapors injected for vapor deposition were adjusted to give a H$_2$O/TiCl$_4$ molar ratio of 0.5. The flow rate of each vapor was the same in all the test runs. The temperatures of the injection nozzles and of the inside of the vapor deposition chamber were all 180 °C.

Various combinations of a multi-orifice nozzle and/or a slit nozzle were used as the upper and lower nozzles 5, 6 with varying angles of the axes of the upper and lower nozzles with respect to the direction of movement of the substrate (depicted as θ$_1$ and θ$_2$, respectively in Figure 1). Except for the case where θ was 90°, each nozzle was tilted in a direction such that it injected a vapor in a reverse direction with respect to the direction of movement of the substrate (in other words, at angles θ$_1$, and θ$_2$ which were both smaller than 90°) and that the two vapor streams injected through the nozzles met each other before reaching the substrate. The length of time after mixing of the TiCl$_4$ vapor and water vapor until contact of the mixed vapors with the substrate was 1 second or shorter in each run.

The substrate leaving the vapor deposition chamber was passed through a heating oven where it was heated for 60 minutes at 400 °C for calcination. The resulting titanium oxide composite material had a titanium oxide film on the individual glass fibers constituting the glass cloth.

In order to evaluate the uniformity of film formation of the titanium oxide film in a transverse (widthwise) direction, a mirror-finished titanium plate having the same width as above was used as a substrate on which vapor deposition was performed under the same conditions as described above. Using the phenomenon that the interference color of the titanium plate coated in this manner changes depending on the thickness of the titanium oxide film formed on the mirror surface of the plate, the uniformity of the film in a transverse direction was evaluated by visual observation in the following manner:

◎: excellent uniformity (even interference color);
○: nearly uniform;
Δ: somewhat non-uniform;
×: highly non-uniform.

Whether the deposition of a powdered product on the substrate was severe or slight was also evaluated by visual observation of the sample formed on the mirror-finished titanium plate.

The photocatalytic activity was evaluated by an aldehyde decomposition test in the same manner as described in Example 2 using a sample formed on the glass cloth substrate. The test piece used in this test was a square piece cut from the sample to a size of 40 mm square.

The results of these tests are shown in Table 5 together with the types of the upper and lower nozzles, the pitch of orifices of a multi-orifice nozzle, if used, and the setting angles of the two nozzles ($\theta_1$ and $\theta_2$).

For comparison, vapor deposition was carried out following a conventional method in which water vapor was merely supplied into the atmosphere within the vapor deposition chamber without injection of a jetted stream of water vapor through a nozzle (Run No. 13). The results of this run are also included in Table 5.

Table 5

| Run No. | Types of Upper and Lower Nozzles* (Upper: $TiCl_4$) (Lower: $H_2O$) | Uniformity in transverse direction | Rate of aldehyde decomposition [ppm/min] | Deposition of powder |
|---|---|---|---|---|
| 1 | Multi-orifice (P5) $\theta_1$: 65° Slit $\theta_2$: 20° | ◎ | 4.2 | Slight |
| 2 | Multi-orifice (P5) $\theta_1$: 65° Multi-orifice (P5) $\theta_2$: 20° | Δ | 3.8 | Slight |
| 3 | Slit $\theta_1$: 65° Slit $\theta_2$: 20° | × | 2.5 | Slight |
| 4 | Slit $\theta_1$: 65° Multi-orifice (P5) $\theta_2$: 20° | ○ | 3 | Slight |
| 5 | Multi-orifice (P5) $\theta_1$: 90° Slit $\theta_2$: 20° | ◎ | 4.5 | Severe |
| 6 | Multi-orifice (P5) $\theta_1$: 80° Slit $\theta_2$: 20° | ◎ | 4.7 | Slight |
| 7 | Multi-orifice (P5) $\theta_1$: 60° Slit $\theta_2$: 20° | ◎ | 4 | Slight |
| 8 | Multi-orifice (P5) $\theta_1$: 30° Slit $\theta_2$: 20° | ◎ | 3 | Slight |
| 9 | Multi-orifice (P5) $\theta_1$: 20° Slit $\theta_2$: 10° | ○ | 2 | Slight |
| 10 | Multi-orifice (P2) $\theta_1$: 65° Slit $\theta_2$: 20° | Δ | 3.5 | Slight |
| 11 | Multi-orifice (P10) $\theta_1$: 65° Slit $\theta_2$: 20° | ○ | 4 | Slight |
| 12 | Multi-orifice (P20) $\theta_1$: 65° Slit $\theta_2$: 20° | × | 3.8 | Slight |
| 13 | Multi-orifice (P10) $\theta_1$: 65° Supply to atmosphere | × | 0.5 | Slight |

*For a multi-orifice nozzle, the figure "5" following "P" in the expression "(P5)", for example, means the pitch of orifices (in mm) of the nozzle.

As can be seen from Table 5, in a conventional method of Run No. 13, although the speed of movement of the substrate and the flow rate and angle of injection of the $TiCl_4$ vapor were the same as in the other test runs, the uniformity in a transverse direction was poor and the photocatalytic activity was also very poor. It is thought that this is because direct supply of water vapor to the atmosphere in the chamber fails to maintain the $H_2O/TiCl_4$ molar ratio at the surface of the substrate within a suitable range, and the ratio may be excessively high or low in some areas, thereby interfering with the uniformity in film formation.

In contrast, in Runs Nos. 1 - 12 according to the first invention in which both the $TiCl_4$ vapor and water vapor were injected through respective injection nozzles with a $H_2O/TiCl_4$ molar ratio of 0.5 such that the time elapsed from mixing of the vapors until contact of the mixed vapors with the substrate was at most 1 second, a significantly improved photocatalytic activity was obtained compared to Run No. 13.

Furthermore, with a preferred combination of nozzles in which the upper nozzle 5 was a multi-orifice nozzle and the lower nozzle 6 was a slit nozzle, except for the cases where the pitch of orifices of a multi-orifice nozzle was too large or small, the uniformity of film formation in a transverse direction was also significantly improved. The occurrence of powder deposition increased when the setting angle of the upper multi-orifice nozzle ($\theta_1$) was 90°. When the setting angle of the upper nozzle was too small, the uniformity in a transverse direction was slightly decreased.

Industrial Applicability

In accordance with the present invention, by forming a titanium oxide film using a vapor deposition method suitable for commercial operation in which vapor deposition is continuously performed on a substrate which is moving in one direction, it is possible to form a titanium oxide film with a high utilization of $TiCl_4$ and at a high rate of film formation, with the resulting film having a high photocatalytic activity and good appearance with minimized powder deposition and being uniform in a transverse direction. Thus, it is made possible to mass-produce a photocatalytic titanium oxide composite material having high performance with low costs.

The film formation process according to the present invention can be applied to film formation of a metal oxide other than titanium oxide. Furthermore, the vapor deposition chamber according to the present invention can be applied to film formation of a material other than a metal oxide as long as the material is formed by a reaction between two vapors. The present invention makes it possible to form a metal oxide film having a good uniformity and adhesion with a good utilization factor of the reactant. Thus, the present invention can be applied not only to the production of a photocatalyst, but also widely to various film-forming technologies.

**Claims**

1. A process for forming a metal oxide film comprising a vapor deposition step in which a vapor of a hydrolyzable metal compound and water vapor are brought into contact with a substrate to form a film of a metal oxide precursor on the surface of the substrate and a calcination step in which the substrate is then heated in an oxidizing atmosphere to convert the precursor into a metal oxide, **characterized in that** in the vapor deposition step, the hydrolyzable metal compound vapor and the water vapor are previously mixed and the mixed vapors are brought into contact with the substrate within 3 seconds after mixing.

2. The process according to claim 1 wherein the vapor deposition step is carried out by injection of jetted streams of the hydrolyzable metal compound vapor and water vapor toward the substrate which is continuously moving, and the mixing is performed by injecting the hydrolyzable metal compound vapor and the water vapor in such a manner that the resulting two jetted vapor streams meet each other before they reach the substrate.

3. The process according to claim 2 wherein the hydrolyzable metal compound vapor is injected in a reverse direction with respect to the direction of movement of the substrate through a multi-orifice nozzle, and the water vapor is injected through a slit nozzle.

4. The process according to claim 2 wherein the angles of the center lines of the streams of the hydrolyzable metal compound vapor and water vapor ($\theta M$ and $\theta H_2O$, respectively) satisfy the following relationship:

$$30^{o} \leq \theta M \leq 80^{o} \ \text{ and } \ \theta M \geq \theta H_2O,$$

and the flow rate of the stream of the hydrolyzable metal compound vapor is greater than that of the water vapor.

5. The process according to any of claims 1 to 4 wherein the hydrolyzable metal compound is a metal chloride.

6. The process according to claim 5 wherein the metal chloride at least predominantly comprises $TiCl_4$, the temperature of the substrate in the vapor deposition step is in the range of 150 - 250 °C, and the heating temperature in the calcination step is in the range of 300 - 600 °C.

7. The process according to claim 6 wherein the proportions of the $TiCl_4$ vapor and the water vapor fed to the vapor deposition step are such that they give a $H_2O/TiCl_4$ molar ratio in the range of 0.05 - 4.

8. The process according to claim 1 wherein the metal oxide film functions as a photocatalyst.

9. A vapor deposition apparatus for forming a film on the surface of a continuously moving substrate by a reaction between two vapors, **characterized in that** the apparatus comprises a multi-orifice nozzle and a slit nozzle disposed in such directions that the vapor streams injected through the respective nozzles meet each other.

10. The vapor deposition apparatus according to claim 9 wherein the multi-orifice nozzle is disposed such that a vapor is injected therethrough in a reverse direction with respect to the direction of movement of the substrate.

11. The vapor deposition apparatus according to claim 9 or 10 wherein the pitch between adjacent orifices of the multi-orifice nozzle is in the range of from 3 mm to 10 mm.

12. The vapor deposition apparatus according to claim 9 or 10 wherein the two vapors are a vapor of a hydrolyzable metal compound and water vapor, and the hydrolyzable metal compound vapor is injected through the multi-orifice nozzle and the water vapor is injected through the slit nozzle.

13. The vapor deposition apparatus according to claim 12 wherein the angle $\theta_1$, between the center axis of the multi-orifice nozzle and the surface of the substrate is in the range of from 30° to 80°, and the angle $\theta_2$ between the center axis of the slit nozzle and the surface of the substrate is smaller than $\theta_1$.

14. The vapor deposition apparatus according to claim 13 wherein angle $\theta_1$ is in the range of from 45° to 75°, and angle $\theta_2$ is in the range of from 10° to 40°.

15. The vapor deposition apparatus according to claim 12 wherein the hydrolyzable metal compound is a metal chloride.

16. The vapor deposition apparatus according to claim 15 wherein the metal chloride at least predominantly comprises $TiCl_4$.

*Fig. 1*

## INTERNATIONAL SEARCH REPORT

| | International application No. |
|---|---|
| | PCT/JP2004/009903 |

A. CLASSIFICATION OF SUBJECT MATTER
    Int.Cl⁷ C23C16/40, C23C16/455, B01J35/02, C01G23/07

According to International Patent Classification (IPC) or to both national classification and IPC

B. FIELDS SEARCHED

Minimum documentation searched (classification system followed by classification symbols)
    Int.Cl⁷ C23C16/00-16/56, C03C5/00-23/00, B01J35/02, C01G23/07

Documentation searched other than minimum documentation to the extent that such documents are included in the fields searched

| Jitsuyo Shinan Koho | 1922-1996 | Jitsuyo Shinan Toroku Koho | 1996-2004 |
|---|---|---|---|
| Kokai Jitsuyo Shinan Koho | 1971-2004 | Toroku Jitsuyo Shinan Koho | 1994-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2000-266902 A (Inax Corp.), 29 September, 2000 (29.09.00), Full text (Family: none) | 1-16 |
| A | JP 61-50892 B2 (BFG Glassgroup), 06 November, 1986 (06.11.86), Full text & DE 2929092 A & GB 2026454 A & BE 877465 A & NL 7905581 A & SE 7906223 A & DK 7903057 A & FR 2456077 A & US 4293326 A & CA 1138725 A & IT 1120990 B | 1-16 |

☒ Further documents are listed in the continuation of Box C. ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 04 October, 2004 (04.10.04) | 19 October, 2004 (19.10.04) |

| Name and mailing address of the ISA/ Japanese Patent Office | Authorized officer |
|---|---|
| Facsimile No. | Telephone No. |

Form PCT/ISA/210 (second sheet) (January 2004)

**INTERNATIONAL SEARCH REPORT**

International application No.

PCT/JP2004/009903

C (Continuation). DOCUMENTS CONSIDERED TO BE RELEVANT

| Category* | Citation of document, with indication, where appropriate, of the relevant passages | Relevant to claim No. |
|---|---|---|
| A | JP 2000-64050 A (Asahi Glass Co., Ltd.),<br>29 February, 2000 (29.02.00),<br>Full text<br>(Family: none) | 1-16 |
| A | JP 7-3463 A (Glaverbel),<br>06 January, 1995 (06.01.95),<br>Full text<br>& GB 2274115 A　　& DE 4400208 A1<br>& DE 4400209 A1　& FR 2700325 A1<br>& FR 2700326 A1　& NL 9400041 A<br>& NL 9400042 A　　& SE 9400037 A<br>& SE 9400038 A　　& CA 2113028 A<br>& CA 2113029 A　　& LU 88451 A<br>& LU 88450 A　　　& JP 7-2548 A<br>& CZ 9400016 A3　& CZ 9400017 A<br>& US 5522911 A　　& BE 1008559 A3<br>& BE 1008560 A3　& CH 687203 A5<br>& CH 687204 A5　　& US 5709726 A<br>& ES 2111418 A1　& ES 2112093 A1<br>& AT 9400014 A　　& AU 9400013 A<br>& US 6112554 A | 1-16 |
| A | JP 7-110994 B2 (Elf Atochem North America,<br>Inc.),<br>29 November, 1995 (29.11.95),<br>Full text<br>& WO 8900549 A　　& AU 8819344 A<br>& ES 2009963 A　　& CN 1030946 A<br>& FI 9000082 A　　& EP 370027 A<br>& US 4928627 A | 1-16 |
| A | JP 5-195230 A (Sumitomo Electric Industries,<br>Ltd.),<br>03 August, 1993 (03.08.93),<br>Full text<br>(Family: none) | 1-16 |
| A | JP 4-80371 A (Canon Inc.),<br>13 March, 1992 (13.03.92),<br>Full text<br>(Family: none) | 1-16 |
| A | JP 9-59777 A (Sekisui Chemical Co., Ltd.),<br>04 March, 1997 (04.03.97),<br>Full text<br>(Family: none) | 1-16 |

Form PCT/ISA/210 (continuation of second sheet) (January 2004)